# EUROPÄISCHE PATENTANMELDUNG

(11) **EP 1 617 352 A2**
(43) Veröffentlichungstag der Anmeldung: **18.01.2006**
(21) Anmeldenummer: 04022138.4
(22) Anmeldetag: 17.09.2004
(51) Int. Cl.: G06K 19/077

(54) **Chipkarte**

(30) Priorität: 04.03.2004 DE 202004003554 U
(71) Anmelder: Novacard Informationssysteme GmbH, 26135 Oldenburg (DE)
(72) Erfinder: Laude Guntram, 28816 Stuhr-Fahrenhorst (DE)
(74) Vertreter: Siekmann, Gunnar

(57) **Zusammenfassung**

Eine Chipkarte mit einem flexiblen Kartenkörper und in dem Kartenkörper angeordneten elektronischen Komponenten wird dahingehend weiterentwickelt, daß mindestens ein Teil der elektrischen Komponenten in einem Gehäuse angeordnet ist, daß der Kartenkörper einen in Form und Größe an das Gehäuse angepaßte Ausnehmung aufweist und daß das Gehäuse beweglich in der Ausnehmung des Kartenkörpers befestigt ist. Dadurch können in dem flexiblen Kartenkörper auch elektrische Komponenten mit vergleichsweise großen Abmessungen aufgenommen werden.

## Beschreibung

Die Erfindung betrifft eine Chipkarte mit einem flexiblen Kartenkörper und in dem Kartenkörper angeordneten elektrischen Komponenten.

Bei der Herstellung von Chipkarten der eingangs genannten Art, insbesondere DIN/ISO-Chipkarten gemäß DIN 7816 werden bisher im wesentlichen drei verschiedene Techniken benutzt, um Komponenten komplexer elektronischer Schaltungen in den Kartenkörper zu integrieren. Derartige Karten sind typischerweise als EC-Karten, Karten für den bargeldlosen Zahlungsverkehr, Kreditkarten oder Krankenversicherungskarten bekannt.

Die allgemein bekannte Chipkarte ist das einfachste Beispiel für eine Implantation elektronischer Komponenten in einen Kartenkörper. Dabei ist das schaltungstragende Silizium auf die Unterseite eines Substrates geklebt, gebondet und vergossen. Durchkontaktierungen zur Oberseite des Substrates erlauben den elektrischen Anschluß an ein peripheres System, insbesondere ein Kartenlesegerät. Dieses sogenannte Chipmodul wird schließlich in einen Kartenkörper aus Kunststoff implantiert. Dabei ist der Kartenkörper nur der Träger des elektronischen Systems ohne eigene elektronische Eigenschaften oder Funktionen.

Während bei der Implantation die elektronischen Bauteile von außen sichtbar sind, stellt sich für die Herstellung sogenannter kontaktloser Karten eine etwas veränderte Situation dar. Hier sollte das Chipmodul nicht sichtbar sein. Dazu wird ein bereits bestückter Schaltungsträger, der insbesondere mit einer Antenne und einem Chip bestückt ist, in die eine mittlere Kartenebene einlaminiert. In der Regel besteht das Substrat des Schaltungsträgers aus dem gleichen Material wie der restliche Kartenkörper, so daß ein weitestgehend homogener Materialverbund durch die Laminierung erreicht wird. Zur Anwendung kommen hier hauptsächlich thermoplastische Kunststoffe, wie zum Beispiel Polyvinylchlorid (PVC), Acrylnitril-Butadien-Styrol (ABS), Polycarbonat (PC) und Polyethylentherephthalat (PET). In den Fällen, in denen Substrat und Kartenmaterial deutlich unterschiedliche Eigenschaften aufweisen, kommen sogenannte Haftvermittler zum Einsatz, mit denen mindestens einer der Verbindungspartner beschichtet wird. Beim Laminierungsverfahren werden unterschiedliche Folien in definierter Abfolge übereinander gelegt und geheftet. Dieser Folienstapel wird dann zwischen zwei Blechen unter Druck und Temperatur zu einem annähernd homogenen Material laminiert. Will man jedoch großflächige Siliziumchips, insbesondere Siliziumchips mit einer Fläche von mehr als 20 mm², verarbeiten, ist dies mit dem Laminierungsverfahren kaum noch möglich. Insbesondere wenn weitere Komponenten integriert werden sollen, würde dies zu einem sehr komplizierten Konstrukt aus Substraten, Kemfolien, Spacer-Folien, Haftvermittler und ähnlichen führen.

Der Erfindung liegt die Aufgabe zugrunde, eine Chipkarte der eingangs genannten Art zu schaffen, bei der auf einem flexiblen Kartenkörper auch elektrische Komponenten mit vergleichsweise großen Abmessungen aufgenommen werden können.

Die Lösung dieser Aufgabe erfolgt mit einer Chipkarte mit den Merkmalen des Schutzanspruchs 1. Vorteilhafte Weiterentwicklungen der Erfindung sind in den Unteransprüchen angegeben.

Bei einer Chipkarte mit einem flexiblen Kartenkörper und in dem Kartenkörper angeordneten elektrischen Komponenten ist es erfindungsgemäß vorgesehen, daß mindestens ein Teil der elektrischen Komponenten in einem Gehäuse angeordnet ist, der Kartenkörper eine in Form und Größe an das Gehäuse angepaßte Ausnehmung aufweist und daß das Gehäuse beweglich in der Ausnehmung des Kartenkörpers befestigt ist. Auf diese Weise kann die bisher bestehende Inkompatibilität von steifen Gehäuse und flexiblen Kartenkörper gelöst werden. Durch die bewegliche Aufhängung wird das Gehäuse von den Biege- und Torsionskräften, die auf den Kartenkörper einwirken, entkoppelt.

Bevorzugt weist das Gehäuse einen den oder die darin angeordneten elektrischen Komponenten umgebenden Metallrahmen auf. Dadurch kann eine besonders hohe Festigkeit erreicht werden. Das Gehäuse ist bevorzugt biegesteif ausgebildet. Das Gehäuse ist dazu bevorzugt aus Edelstahl, Keramik oder faserverstärktem Kunststoff hergestellt. Es besteht aus einem Unterteil und einem Oberteil. Man spricht hier auch von Topf und Deckel. Nachdem in das Gehäuse die elektronischen Komponenten eingebracht sind, wird das Gehäuse bevorzugt noch vergossen.

Das Gehäuse und der Kartenkörper sind bevorzugt in mindestens zwei Bereichen miteinander verbunden. Werden nur zwei Verbindungsbereiche vorgesehen, so sind diese entsprechend steif auszubilden, so daß eine vollständige Verdrehung des Gehäuses in dem Kartenkörper verhindert wird. Bevorzugt sind das Gehäuse und der Kartenkörper in drei Bereichen miteinander verbunden. Dabei schließen die Bereiche jeweils bevorzugt einen Winkel von etwa 120° zueinander ein. Durch derartige Befestigungen kann das Gehäuse in dem Kartenkörper beweglich aufgehängt sein. Das Gehäuse ist mit dem Körper bevorzugt mit Aufhängelaschen verbunden. Die Verbindung zwischen Chipkarte und Gehäuse ist bevorzugt membranartig ausgebildet. Die membranartige Verbindung zwischen Chipkarte und Gehäuse kann in einer anderen bevorzugten Ausführungsform umlaufend um das gesamte Gehäuse ausgebildet sein.

In einer bevorzugten Ausgestaltung der Erfindung ist jede Ausnehmung durchgehend durch den Kartenkörper ausgebildet. Bevorzugt ist das Gehäuse dann mit einer Dicke ausgebildet, die der Dicke der übrigen Karte entspricht, so daß zunächst eine durchgehende Oberfläche gebildet ist. Bei einer Verbiegung des Kartenkörpers wird das biegesteife Gehäuse dann in seiner beweglichen Lagerung gegenüber dem Kartenkörper etwas verdreht. Alternativ ist es auch möglich, die Ausnehmung nicht vollständig durch den Kartenkörper auszubilden, also entweder einseitig oder beidseitig verbleibende Restschichten in dem Kartenkörper vorzusehen. Das Gehäuse müßte dann jedoch etwas kleiner sein als die so gebildete Ausnehmung, um eine Beweglichkeit innerhalb dieser Ausnehmung zu gewährleisten.

In einer anderen bevorzugten Weiterentwicklung der Erfindung sind die in dem Gehäuse angeordneten elektrischen Komponenten mit einem flexiblen Schaltungsträger verbunden. Der flexible Schaltungsträger bildet bevorzugt auch eine mechanische Verbindung zwischen dem Gehäuse und dem Kartenkörper aus. Gleichzeitig kann der flexible Schaltungsträger auch zur Herstellung einer elektrischen Verbindung zwischen Gehäuse und Kartenkörper genutzt werden. Der flexible Schaltungsträger ist bevorzugt derart geformt, daß er im wesentlichen an die Form des Gehäuses angepaßt ist und sich außerdem bevorzugt daran nach außen erstreckende Verbindungsbereiche vorgesehen sind. Bevorzugt sind dabei drei Verbindungsbereiche vorgesehen, von denen sich einer zur Herstellung einer elektrischen Verbindung bis zu einem Chipmodul erstreckt. Die elektronischen Komponenten werden dabei auf dem flexiblen Schaltungsträger angeordnet, der bestückte Teil des Schaltungsträgers wird dann in das Gehäuse integriert. In verschiedenen Bereichen verläßt der unbestückte Schaltungsträger das Gehäuse, in der Art, daß er in einem oder mehreren Bereichen eine elektrische Verbindung zum kontaktbehafteten Chipmodul herstellt und andererseits Aufhängelaschen bildet, die dann die membranähnliche Aufhängung realisieren. Einige Aufhängelaschen bilden ausschließlich eine mechanische Verbindung, während andere eine mechanische und eine elektrische Verbindung bilden.

Nach einer weiteren günstigen Ausführungsform der Erfindung sind die in dem Gehäuse angeordneten elektrischen Komponenten ausschließlich untereinander elektrisch miteinander verbunden. Man kann hier auch von einer in dem Gehäuse angeordneten autarken Schaltung sprechen. Bevorzugt ist dann in dem Kartenkörper eine Spule gebildet, die zur kontaktlosen Energieübertragung zu den elektrischen Komponenten des Gehäuses ausgebildet ist. Derartige Chipkarten werden auch als Hybrid-Chipkarten bezeichnet. Ein in dem Gehäuse vorgesehener Schaltungsträger weist Aufhängelaschen oder Verbindungsbereiche mit ausschließlich mechanischer Funktion auf. Diese Verbindungslaschen sind dann frei von elektrischen Verbindungen zu eventuell außerhalb des Gehäuses angeordneten elektrischen Komponenten der Chipkarte.

In einer anderen bevorzugten Ausführungsform weist das Gehäuse Versteifungsstege auf. Diese sind bevorzugt in ihrer Position und Größe an die im Gehäuse angeordneten elektrischen Komponenten angepaßt. Der Schaltungsträger weist bevorzugt Ausnehmungen für diese Versteifungsstege des Gehäuses auf. Der Schaltungsträger kann daher ohne weiteres einfach in das Gehäuse eingelegt werden. Bevorzugt ist das Gehäuse rund ausgebildet. Ein derartiges Gehäuse läßt sich besonders einfach integrieren und auch beweglich gestalten, ohne daß es verkanten könnte. Auch andere, insbesondere elliptische oder ovale Ausgestaltungen des Gehäuses, in manchen Fällen sogar eckige Formen, sind möglich. Bevorzugt ist das Gehäuse derart dimensioniert, daß es etwa 5 % bis 25 %, insbesondere 8 % bis 15 % und in einer bevorzugten Ausgestaltung 10 % bis 13 % der Fläche der Chipkarte einnimmt. Dadurch wird erreicht, daß die Chipkarte in ihrem Hauptbereich flexibel bleibt und nur ein vergleichsweise kleiner Bereich als starrer Gehäuseblock oder auch als "Coin" ausgebildet ist. Die Chipkarte wird bevorzugt nach einem Sandwich-Verfahren hergestellt. Beim Sandwich-Verfahren wird eine bereits assemblierte elektronische Einheit auf einem fertig laminierten Kartenunterteil fixiert und anschließend das ebenfalls fertig laminierte Kartenoberteil mit dem Kartenunterteil zu einem kompletten Kartenkörper verklebt. In einer anderen bevorzugten Ausführungsform der Erfindung wird die Chipkarte mit einem Spritzgussverfahren hergestellt.

Ein weiterer Aspekt der Erfindung besteht in der Bereitstellung eines Gehäuses mit darin aufgenommenen elektrischen Komponenten zur Verwendung in einer Chipkarte der oben beschriebenen Art. Weiterhin ist es ein Aspekt der Erfindung, ein Gehäuse zur Aufnahme von elektrischen Komponenten zur Verwendung in einer oben beschriebenen Chipkarte bereitzustellen.

Nachfolgend wird die Erfindung anhand eines in der Zeichnung dargestellten bevorzugten Ausführungsbeispiels weiter erläutert. Im einzelnen zeigen die schematischen Darstellungen in:
- Fig. 1:: eine Draufsicht auf eine erfindungsgemäße Chipkarte;
- Fig. 2:: eine Seitenansicht einer erfindungsgemäßen Chipkarte gemäß Fig. 1;
- Fig. 3:: einen vergrößerten Ausschnitt gemäß Fig. 2 einer unbelasteten Chipkarte;
- Fig. 4:: einen vergrößerten Ausschnitt gemäß Fig. 2 einer belasteten Chipkarte;
- Fig. 5:: eine perspektivische Ansicht eines Bodens eines Gehäuses einer erfindungsgemäßen Chipkarte;
und
- Fig. 6:: eine Draufsicht auf einen Teil eines Schaltungsträgers zur Verwendung in einer erfindungsgemäßen Chipkarte.

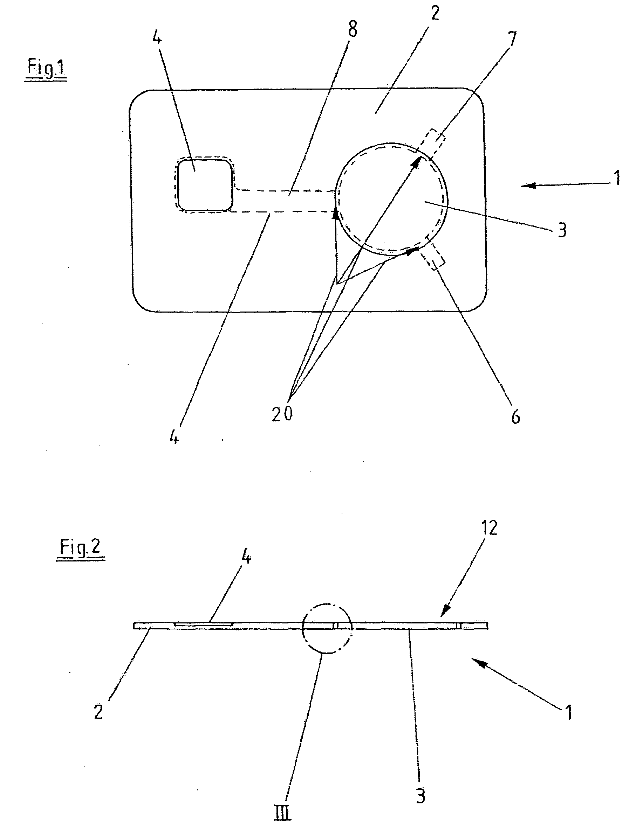

In Fig. 1 ist eine Draufsicht auf eine Chipkarte 1 dargestellt, die im wesentlichen einen flexiblen Kartenkörper 2, ein darin eingesetztes Chipmodul 4 und ein Gehäuse 3 aufweist, wobei das Gehäuse 3 zur Aufnahme eines oder mehrerer elektrischer Komponenten vorgesehen ist. Dies können beispielsweise eine Batterie, eine Tastatur, ein Display, Fingerprint-Sensoren oder ein großflächiger Controller-Chip sein. Gepunktet angedeutet ist in dem Kartenkörper 2 ein Schaltungsträger 5 vorgesehen, der sich durch das Gehäuse 3 erstreckt und über das Gehäuse 3 hinaus drei Aufhängelaschen 6, 7 und 8 bildet, wobei die Aufhängelasche 8 verlängert ausgebildet ist und gleichzeitig eine elektrische Verbindung zum Chipmodul 4 ausbildet. In dem Kartenkörper 2 ist eine Ausnehmung oder Aussparung vorgesehen, die sich von oben bis unten vollständig durch den Kartenkörper 2 erstreckt und in der das Gehäuse 3 angeordnet ist. Zwischen dem Gehäuse 3 und dem Kartenkörper 2 verbleibt ein kleiner Spalt, so daß sich das Gehäuse 3 relativ zum Kartenkörper 2 verkantungsfrei bewegen kann.

In Fig. 2 ist eine Seitenansicht der Chipkarte 1 gemäß Fig. 1 dargestellt. Man erkennt, daß der Kartenkörper 2 insgesamt sehr flach ausgebildet ist und daß insbesondere die Ausnehmung 12 durchgehend durch den gesamten Kartenkörper 2 ausgebildet ist und in dieser Ausnehmung das Gehäuse 3 angeordnet ist, das in seiner Dicke der Dicke des Kartenkörpers 2 entspricht. Das Chipmodul 4 ist über einen Teilbereich der Tiefe des Kartenkörpers 2 ausgebildet und mit Hilfe des Schaltungsträgers 5 mit dem Gehäuse 3 verbunden.

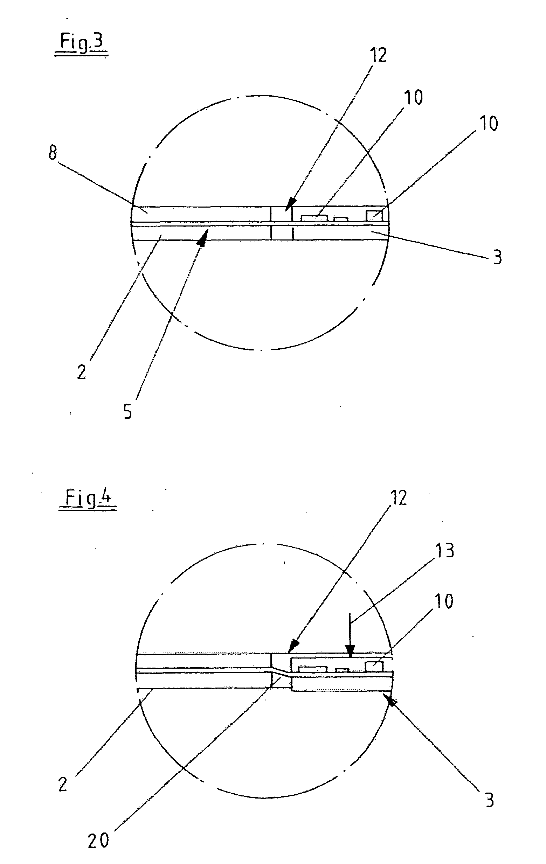

In Fig. 3 ist ein vergrößerter Ausschnitt gemäß III in Fig. 2 dargestellt. Die Chipkarte ist dabei unbelastet bzw. im ungebogenen Zustand dargestellt. Im linken Bereich der Fig. 3 ist der Verbindungsbereich 8 des Schaltungsträgers 5 zu erkennen, der sich durch den Kartenkörper 2 erstreckt. Der Schaltungsträger 5 reicht bis in das Gehäuse 3 hinein, in dem auch die elektrischen Komponenten 10 angeordnet sind. In einem Zwischenbereich bzw. einem verbleibenden Spalt zwischen Gehäuse 3 und Kartenkörper 2 erfolgt die Verbindung nur durch den Schaltungsträger 5. Das Gehäuse 3 ist hier membranartig in dem Kartenkörper 2 aufgehängt. Man kann den hier dargestellten Randbereich auch als Membranzone 20 bezeichnen.

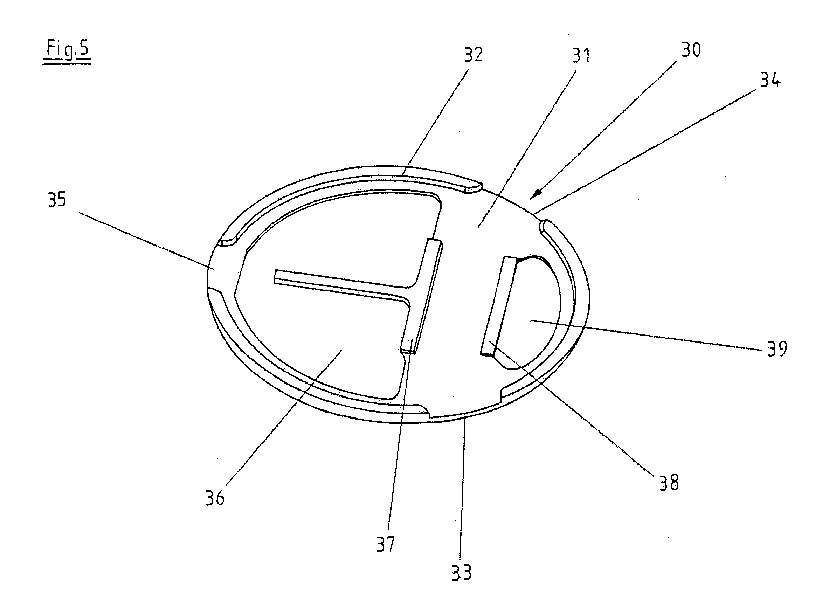

In Fig. 4 ist der gleiche Bereich wie in Fig. 3 dargestellt, jedoch ist hier das Gehäuse 3 in Richtung des Pfeiles 13 mit einer Kraft F beaufschlagt. Das Gehäuse 3 verschiebt sich dabei gegenüber dem Kartenkörper 2 nach unten und ist daher nicht mehr bündig in der Ausnehmung 12 angeordnet, sondem steht auf der Unterseite etwas aus der Ausnehmung 12 heraus. Im Übergangsbereich zwischen Kartenkörper und Gehäuse, in dem mit Hilfe des Schaltungsträgers 8 eine Verbindung besteht, erkennt man die Verbiegung des Schaltungsträgers 5. Hier ist die Membranzone 20 ausgebildet.

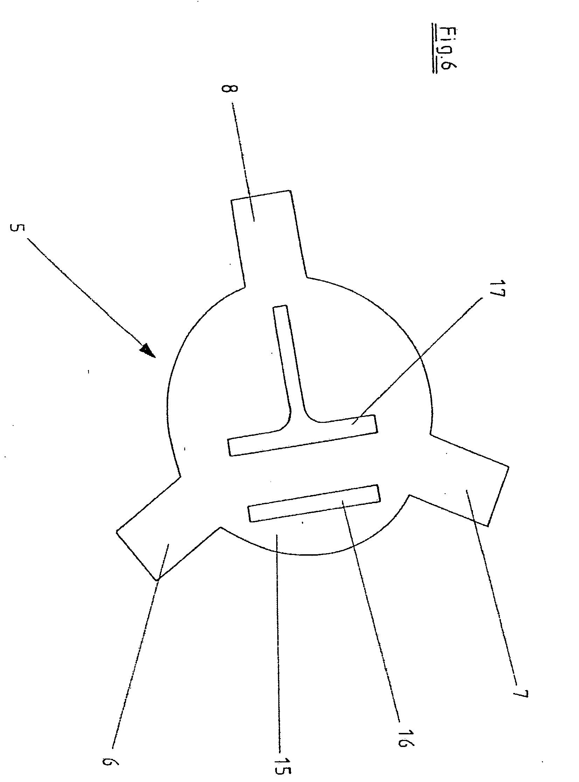

In Fig. 5 ist ein Boden 30 des Gehäuses 3 in einer perspektivischen Ansicht dargestellt. Zur Fertigstellung des Gehäuses 3 müßte auf diesen Boden 30 noch ein ebener Deckel aufgelegt werden, der hier nicht dargestellt ist. Der Boden 30, der auch als Topf bezeichnet wird, hat im Außenbereich einen umlaufenden Rand 32, der als Auflagefläche für den Deckel dient. Der Rand 32 weist drei Durchbrüche oder Ausnehmungen 33, 34 und 35 auf, die jeweils unter einem Winkel von 120° zueinander angeordnet sind und durch die Befestigungslaschen oder Aufhängelaschen zum Kartenkörper aus dem Gehäuse herausgeführt werden können. Weiterhin weist der Boden 30 etwas vertiefte Bereiche 36 und 39 und im Randbereich dieser vertieften Bereich angeordnete Versteifungsstege 37 und 38 auf, deren Größe und Position in Abhängigkeit von den aufzunehmenden oder im Gehäuse zu plazierenden elektrischen Komponenten ausgewählt ist.

In Fig. 6 ist ein Schaltungsträger 5 dargestellt, der an den in Fig. 5 dargestellten Boden 30 des Gehäuses angepaßt ist. Neben der runden Grundfläche 15, die an die Form des Bodens 30 des Gehäuses angepaßt ist, weist der Schaltungsträger 5 auch die Aufhängelaschen 6, 7 und 8 auf. Im Innenbereich sind Ausnehmungen 16 und 17 vorgesehen, die in ihrer Größe, Position und Abmessungen an die Versteifungsstege 37 und 38 angepaßt sind.

## Patentansprüche

1. Chipkarte mit einem flexiblen Kartenkörper (2) und in dem Kartenkörper angeordneten elektrischen Komponenten (10),
**dadurch gekennzeichnet**,
mindestens ein Teil der elektrischen Komponenten (10) in einem Gehäuse (3) angeordnet ist,
daß der Kartenkörper (2) eine in Form und Größe an das Gehäuse (3) angepaßte Ausnehmung (12) aufweist, und
daß das Gehäuse (3) beweglich in der Ausnehmung (12) des Kartenkörpers (2) befestigt ist.

2. Chipkarte nach Anspruch 1, **dadurch gekennzeichnet, daß** das Gehäuse (3) biegesteif ausgebildet ist.

3. Chipkarte nach einem der Ansprüche 1 oder 2, **dadurch gekennzeichnet, daß** das Gehäuse (3) und der Kartenkörper (2) in mindestens zwei Bereichen miteinander verbunden sind.

4. Chipkarte nach einem der vorhergehenden Ansprüche, **dadurch gekennzeichnet, daß** das Gehäuse (3) und der Kartenkörper (2) in drei Bereichen, die jeweils einen Winkel von etwa 120° einschließen, miteinander verbunden sind.

5. Chipkarte nach einem der vorhergehenden Ansprüche, **dadurch gekennzeichnet, daß** das Gehäuse (3) und der Kartenkörper (2) membranartig miteinander verbunden sind.

6. Chipkarte nach einem der vorhergehenden Ansprüche, **dadurch gekennzeichnet, daß** die Ausnehmung (12) durchgehend durch den Kartenkörper ausgebildet ist.

7. Chipkarten nach einem der vorhergehenden Ansprüche, **dadurch gekennzeichnet, daß** die in dem Gehäuse (3) angeordneten elektrischen Komponenten (10) mit einem flexiblen Schaltungsträger (5) verbunden sind.

8. Chipkarte nach Anspruch 7, **dadurch gekennzeichnet, daß** der flexible Schaltungsträger (5) eine mechanische Verbindung zwischen Gehäuse (3) und Kartenkörper (2) bildet.

9. Chipkarte nach einem der Ansprüche 8 oder 9, **dadurch gekennzeichnet, daß** die Form des Schaltungsträgers (5) im wesentlichen an die Form des Gehäuses (3) angepaßt ist und der Schaltungsträger (5) sich nach außen erstreckende Verbindungsbereiche (6, 7, 8) aufweist.

10. Chipkarte nach einem der vorhergehenden Ansprüche, **dadurch gekennzeichnet, daß** das Gehäuse (3) Versteifungsstege (37, 38) aufweist.

11. Chipkarte nach einem der vorhergehenden Ansprüche, **dadurch gekennzeichnet, daß** die in dem Gehäuse (3) angeordneten elektrischen Komponenten (10) ausschließlich untereinander elektrisch verbunden sind.

12. Chipkarte nach einem der Ansprüche 7 bis 11, **dadurch gekennzeichnet, daß** der Schaltungsträger (5) Ausnehmungen (16, 17) für die Versteifungsstege (37, 38) des Gehäuses (3) aufweist.

13. Chipkarte nach einem der vorhergehenden Ansprüche, **dadurch gekennzeichnet, daß** das Gehäuse (3) rund ausgebildet ist.

14. Chipkarte nach einem der vorhergehenden Ansprüche, **dadurch gekennzeichnet, daß** das Gehäuse (3) etwa 5 % bis 25 %, insbesondere 8 % bis 15 %, insbesondere 10 % bis 13 % der Fläche der Chipkarte (1) einnimmt.

15. Chipkarte nach einem der vorhergehenden Ansprüche, **dadurch gekennzeichnet, daß** die Chipkarte (1) mit einem Sandwich-Verfahren hergestellt ist.

16. Chipkarte nach einem der Ansprüche 1 bis 14, **dadurch gekennzeichnet, daß** die Chipkarte (1) mit einem Spritzgussverfahren hergestellt ist.

17. Gehäuse mit darin aufgenommenen elektrischen Komponenten (10) zur Verwendung in einer Chipkarte (1) nach einem der vorhergehenden Ansprüche.

18. Gehäuse zur Aufnahme von elektrischen Komponenten (10) zur Verwendung in einer Chipkarte (1) nach einem der Ansprüche 1 bis 16.
